# EUROPEAN PATENT APPLICATION

(11) **EP 1 784 063 A1**
(43) Date of publication of application: **09.05.2007**
(21) Application number: 05300903.1
(22) Date of filing: 08.11.2005
(51) Int. Cl.: H05K 1/00, H05K 1/02, H05K 1/14, H05K 3/02, H01P 5/107

(54) **Circuit board with microelectronic elements assembled thereon and method for producing such circuit board**

(71) Applicant: Alcatel Lucent, 75008 Paris (FR)
(72) Inventor: Peulevey, Nicolas, 76260, EU (FR); Aucourt, Jerome, 92400, COURBEVOLE (FR)
(74) Representative: Chaffraix, Sylvain

(57) **Abstract**

Circuit board (1) and method of producing thereof, the circuit board having a cavity for microstrip to waveguide transition means (2) defined by a hollow space on the walls of which a protection layer (21) is provided. A microelectronic substrate (33) is placed upon an adhesive film (31) adhered onto a surface of the circuit board (1), the adhesive film being pre-cut in selected areas (32) thereof providing openings therethrough. A metal layer (5) is disposed on the resulting structure, wherein a selected part (51) of the metal layer (5) present on a surface of microelectronics substrate (33), facing the hollow space defined by the cavity for microstrip to waveguide transition means (2) is removed.

## Description

The present invention relates to the field of radio frequency units used in point to point, or point to multipoint, telecommunication systems. Preferably, the invention relates to such end units used in microwave transmission and reception in which microelectronic elements, having relatively small dimensions are to be assembled on printed circuit boards.

### BACKGROUND OF THE INVENTION

As it is well known, printed circuit boards are widely used in equipment incorporating electronic circuits. Radio frequency units are among such equipment and thus incorporate, generally speaking, one or more circuit boards. In particular when the equipment is to be used for telecommunication by microwave, specific elements or devices capable of operating under microwave frequencies are required. For the purpose of simplification, the term "element" will be used hereinafter for all reference to electronic passive or active elements, devices, integrated circuits, and the like, suitable for assembly on a printed circuit board within the scope of the present invention.

Usually, microwave elements such as aka dies or chips are of a relatively small size and require special finishing processes; for example often they must be glued on a supporting surface in clean rooms using low-speed machines. This type of elements are generally called Monolithic Microwave Integrated Circuits (sometimes also called: Millimetric Microwave Integrated Circuits) hereinafter referred to as MMICs and are well-known to a person skilled in the art.

On the other hand, there exist the so-called Surface Mount Devices, hereinafter referred to as SMDs which are conventional discrete elements and are usually mounted on circuit boards using high speed machines. Recent technologies now allow, and increasing tend to, integrating MMICs in SMD type packages, so that they can be mounted using SMD mounting machines which typically operate at high-speed. However, this is not an easy task and the known solutions usually employ different processes for mounting MMICs and SMD as will be described in further detail below.

Microwave emission and reception equipment frequently use microstrip to waveguide transition means, hereinafter referred to as MWT. MWTs, as it is well known in the art, are used for providing transition, i.e. coupling the propagation of electromagnetic energy, from a microstrip type medium to a waveguide medium, or vice-versa. Waveguides and microstrips are both well known in the art for their use as transmission media for transmitting electromagnetic energy from one point to another, the former being usually constructed based on a hollow structure made of a conductive material through which electromagnetic energy can propagate; and the latter being usually constructed based on a structure comprising an electrically conductor line separated from a ground plane by a layer of dielectric material disposed there-between, the structure being also capable of allowing electromagnetic energy propagation.

A problem associated with the MWTs is that the structure of the waveguide, generally requiring some space, complicates the assembly process of the circuit board, in particular if it is desired to incorporate the whole transition apparatus on an integrated substrate of small dimensions.

In order to integrate MWTs and microelectronic elements, such as MMICs in a circuit board, some solutions are known. One of such solutions is based on assembling the microelectronics substrate, alumina and MMICs on a metallic part, the metallic part generally called the soleplate, and incorporating on the circuit board an aluminum waveguide for providing MWT.

A solution of this kind is known from EP-A-1357591. According to the solution provided in this document, adhesive material is deposited on certain regions on a base plate and a substrate is deposited on the adhesive material and adhered by pressure to the base plate, leaving open certain contact points wherein adhesive material is not present. Next, electronic components are placed on some of said contact points, and electrical connections are provided between the components and the neighboring substrates.

While the above solution provides certain improvements in the process of assembly of elements on a base plate, it presents some drawbacks when circuit boards need to be obtained by mass production. In fact, the solution disclosed in EP-A-1357591 is mainly directed to a method of assembly of component on a metallic base plate where elements such as MMICs, MWTs may be mounted. However, if it is desire to mount SMDs, these elements would usually require to be mounted on a printed circuit board and not a metallic base plate. As a consequence, an assembly involving MMICs, MWTs and SMDs would require two different parts, namely one part being a metallic base plate (soleplate) for mounting the MMICs and MWT, and another part being a printed circuit board for mounting SMDs.

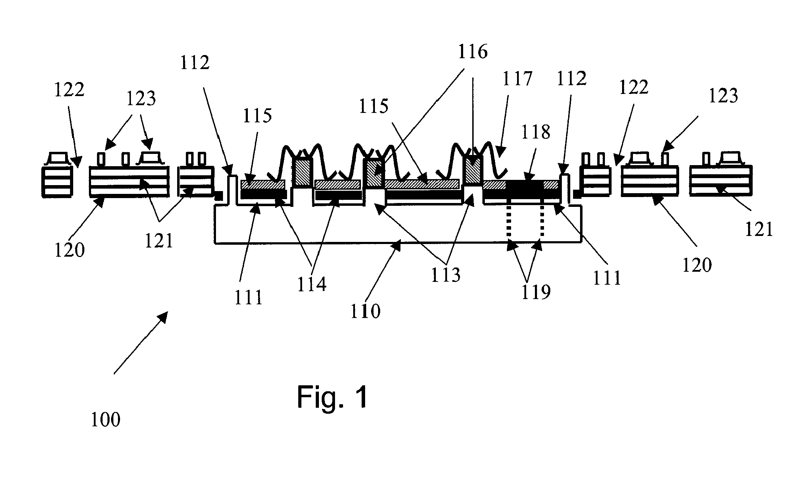

Figure 1 shows, in partial cross section, an exemplary board arrangement 100 assembled using conventional techniques, in which said two parts are present. A first part represents an assembly combination having a base plate 110 made of metallic material and a second part 120 represents an assembly combination using a printed circuit board.

The first part of the board arrangement 100 is structured in accordance with the process described in EP-A-1357591. The structure comprises, in brief description, recessed zones 111 defined between side stubs 112 located around the base plate and contact points 113 in internal regions thereof. A layer of adhesive material 114 is selectively deposited on the recessed zones 111, and next, layers of substrate or alumina 115 are deposited on the adhesive layer 114. Contact points 113 are used for mounting MMICs 116 thereon, which are fixed in place by bonding means 117. The process allows for incorporating an MWT 118, with an MWT waveguide structure 119 in the form of a cavity, as shown with dotted lines in figure 1.

The process of mounting the elements 116 on the base plate 110, according to the known solution is conventionally performed by using specific material such as a specific glue and by using a mounting machine for assembly of the elements on the base plate and their bonding to the board, which is carried out in microelectronics clean rooms requiring intervention of specialized personnel.

The second part of the board arrangement 100 comprises a printed circuit board 120, having multiple layers 121 and holes 122, the holes traversing through the board in vertical direction with respect to a horizontal plane of the board as shown in the figure. Upon selected zones of the board, SMDs 123 are placed, usually by automated procedures such as for example the so-called reflow process in a conventional workshop.

The reflow process, as is well known in the related art, makes use of hot air which is forced into a chamber wherein the board to be processed is placed.

As a consequence of the hot temperature of the flowing air, the board is heated giving rise to the melting of soldering material present at selected soldering points, and thereby forming soldered contacts. In this manner, a substantial number of contact points may be created by one process, which could be automatic and without a need of intervention of technical personnel.

From the above discussion it is therefore appreciated that the known solutions provide different mounting techniques for elements such as MWTs and MMICs on the one hand, and SMDs on the other and require two different types of supporting material, namely a metallic soleplate and a printed circuit board. Also the known solution of assembly on a soleplate does not allow the use of automated processes such as for example the reflow process. Consequently the known solutions give rise to undesirable increase in costs of material and manpower.

It is therefore desired to provide a method for assembly of a circuit board, and a circuit board, which do not suffer from the above-mentioned drawbacks.

### DESCRIPTION OF THE INVENTION

The above objective is reached by using the solution proposed by the present invention according to which the aluminium waveguide soleplate used for the structure of the MWT, which is not suitable for use in a reflow process, is replaced by a printed circuit board with multiple layers. The MWT is made by means of metallization of a cavity in the bulk of the printed circuit board at selected zones thereof, as will be described in further detail below.

In this manner it will be possible to assemble SMD components, microwave components and common components all in one reflow process.

Accordingly one object of the present invention is that of providing Method for assembling a circuit board, the circuit board comprising multiple layers being formed by successive layers of conductive and non-conductive materials, the circuit board further comprising a cavity for microstrip to waveguide transition means in the form of a hollow space disposed within the bulk of the circuit board, characterized by comprising the steps of:
- depositing a protection layer on the walls of the cavity for microwave to waveguide transition means;
- adhering an adhesive film onto a surface of the board, the adhesive film being pre-cut in selected areas thereof;
- placing a microelectronic substrate on the adhesive film;
- depositing a metallic layer on the resulting structure; and
- removing a selected part of the metal layer present on a surface of microelectronics substrate, facing the hollow space defined by the cavity for microstrip to waveguide transition means.

Another object of the present invention is that of providing a circuit board for assembly of circuit elements comprising multiple layers formed by successive thin layers of conductive and non-conductive materials and a cavity for microstrip to waveguide transition means in the form of a hollow space in the bulk of the circuit board, the circuit board being characterized by comprising a protection layer on the walls of the cavity for microstrip to waveguide transition means, an adhesive film adhered onto a surface of the circuit board, the adhesive film being pre-cut in selected areas thereof providing openings therethrough, a microelectronic substrate placed upon the adhesive film, and metal layer disposed on the resulting structure, wherein a selected part of the metal layer present on a surface of microelectronics substrate, facing the hollow space defined by the cavity for microstrip to waveguide transition means is removed.

Yet another object of the present invention is the use of the circuit board of produced according to the present invention in radio frequency microwave transmission and/or reception equipment

These and further features of the present invention are explained in more detail in the following description as well as in the claims with the aid of the accompanying drawings.

### BRIEF DESCRIPTION OF THE DRAWINGS

Figure 1 is a schematic representation in partial cross section of a circuit board arrangement assembled by known solutions.
Figures 2a, 2b, 2c, 2d, 2e, 2f represent in partial cross section, various exemplary steps of a process of producing a printed circuit board according to the present invention.

### EXAMPLES OF PREFERRED EMBODIMENTS

In the present description, the terms partial cross section are referred to a schematic representation of the boards generally seen in cross section view although certain parts not relevant for the understanding of the invention are not shown for the sake of simplicity.

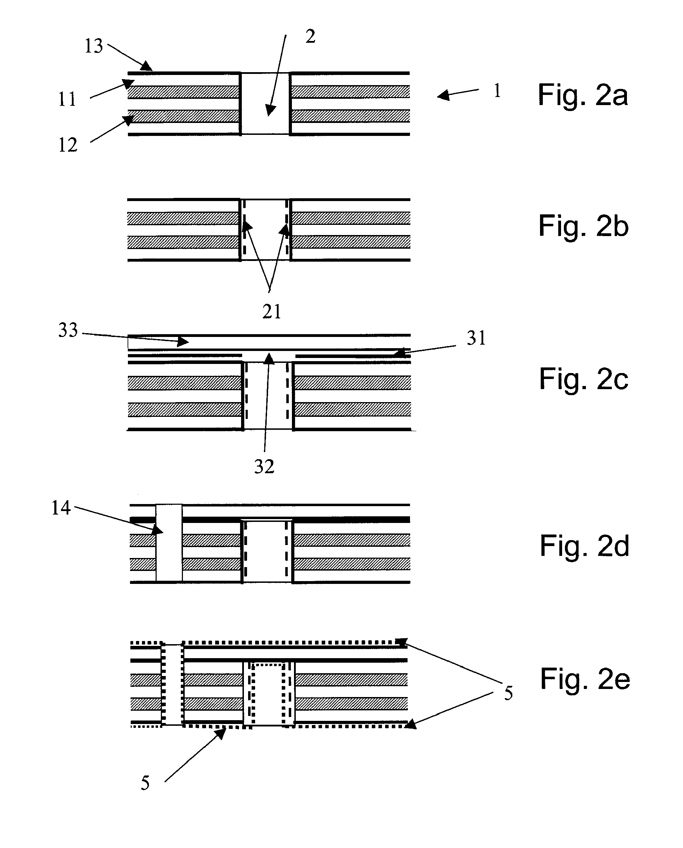

Figure 2a represents an example of a printed circuit board 1, hereinafter referred to as PCB, shown in partial cross section having multiple layers 11, 12 and optionally a covering layer 13 usually made of copper, wherein the multiple layers of the circuit board are formed by successive thin layers of conductive 12 and non-conductive 11 materials bonded together. Multiple layer PCBs and their use are known in the art.

The multiple layers of the printed circuit board are preferably made of material with a high grounding level in order to allow for good thermal dissipation and electrical isolation in the board.

The PCB of figure 2a further presents a cavity for a MWT waveguide configuration 2 in the form of a hollow space disposed longitudinally through at least a part of the bulk of the PCB as viewed for the partial cross section of the PCB, i.e. in figure 2a the waveguide is also seen in partial cross section view. The MWT waveguide 2 may be of any suitable dimension and configuration according to the specific design requirements for each application.

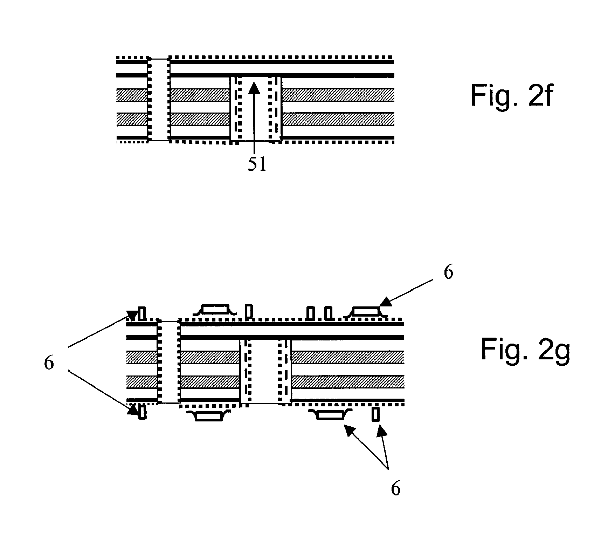

In a next step, shown in figure 2b, a protection layer 21 is deposited on the walls of the MWT waveguide 2. The protection layer 21 is preferred for the purpose of protecting the metal at the edge portions of the cavity 2 at a later stage of the procedure when etching is performed on a determined portion of the metal layer in the cavity as will be described in relation to figure 2f. The material used for protection layer 21 may be selected from the conventional materials available to a person skilled in the art, for example the material may be a NiAu alloy. The method used for depositing the protection layer 21 on the walls of the MWT waveguide 2 may be selected from any conventional method known to a person skilled in the related art for example by conventional copper deposition processes such as for example electroless or electrolytic deposit.

It is to be noted however that the above step of procedure, in relation figure 2b, is optional. The invention also may be carried out without performing this step however the task of removing the metal layer at an upper surface of the cavity, as will be described in relation to figure 2f, becomes more complicated as it would require more accuracy in the operation.

Figure 2c shows a next step of the procedure of the invention in which an adhesive film 31 is adhered onto the upper surface of the PCB. The adhesive film is preferably of a "flow-resistant" type, meaning that when pressure is exerted on the film, the adhesive material does not flow sideways as a result of the pressure. The adhesive film is pre-cut in selected areas 32 thereof in order to allow openings therethrough. In figure 2c an opening 32 is provided over the MWT waveguide 2.

Alternatively, in case a flow-resistant type material is not used, the process of the invention may also be performed by the use of an adhesive material which may flow after application or exertion of pressure; however in this case the procedure becomes more complicated as compared to the use of flow-resistant material because a higher degree of accuracy and control is needed to avoid the flow of the adhesive material.

Next a microelectronic substrate 33 is placed upon the PCB and pressed onto the adhesive film 31 in order to obtain a firm adhesion on the PCB. The microelectronics substrate may be of any known material suitable for the purpose of element assembly.

Optionally , in a subsequent step shown in figure 2d, thru-holes are provided at selected parts of the board 14. The hole may be made for example by drilling techniques.

In a next step, shown in figure 2e, the whole assembly obtained in the previous steps is subjected to metallization. Metallization is performed by any known technique such as for example electroless or electrolytic deposit. The metal used may preferably be copper, however other types of metal providing good conductive properties may also be used. In figure 2e, the metal layer thus obtained is shown by dotted lines with reference numeral 5.

Once the metallization is performed, referring now to figure 2f, a part 51 of the metal layer present on the lower surface of microelectronics substrate 33, facing the hollow space defined by the cavity for the MWT waveguide is removed by means of etching techniques. The removal of the metal layer leaves the corresponding surface of the substrate free of metal. This removal therefore provides the possibility of allowing interchange of signals between the cavity and the substrate which after removal of the metal layer acts as an antenna for the MWT.

In this manner a PCB is prepared having a MWT waveguide 2 built therein, without the need for using a metallic soleplate and by mean of a process which may be adapted for automation and mass production without difficulty. The metalized parts of the PCB may be etched according to the design of the circuit required and SMDs may be mounted on both sides of the PCB using automated processes and in conventional (not necessarily "clean") workshops.

An example of an already assembled PCB produced using the solution of the present invention is shown in figure 2g, wherein a built-in MWT waveguide 2, a thru-hole 14, and mounted elements 6 are schematically represented.

One advantage of the solution proposed by the present invention is that it provides the possibility of a high level of industrialisation for boards used for microwave systems compared to the prior art solutions. This advantage further gives rise to cost reduction as the method of the invention is not dependent on intervention of personnel, it is easily reproducible and it provides for high yield.

As stated above, using the solution of the invention makes it possible to use automated processes such as the reflow process for assembling a microwave board, to assemble microelectronics elements as well as conventional electronic elements on one and the same board, and to integrate microwave and intermediate frequencies functions.

## Claims

1. Method for assembling a circuit board, the circuit board (1) comprising multiple layers (11, 12) being formed by successive layers of conductive 12 and non-conductive 11 materials, the circuit board further comprising a cavity for microstrip to waveguide transition means (2) in the form of a hollow space disposed within the bulk of the circuit board (1), **characterized by** comprising the steps of:
- adhering an adhesive film (31) onto a surface of the board, the adhesive film being pre-cut in selected areas (32) thereof;
- placing a microelectronic substrate (33) on the adhesive film (31);
- depositing a metal layer (5) on the resulting structure; and
- removing a selected part (51) of the metal layer (5) present on a surface of microelectronics substrate 33, facing the hollow space defined by the cavity for microstrip to waveguide transition means (2).

2. Method according to claim 1 further comprising the step of depositing a protection layer (21) on the walls of the cavity for microwave to waveguide transition means (2).

3. Method according to claim 2, wherein the material used for protection layer (21) is NiAu alloy.

4. Method according to any one of claims 1 to 3, wherein thru-holes (14) are made at selected parts of the board (1).

5. Method according to any one of the previous claims wherein the adhesive film (31) is substantially resistive against flowing sideways as a result of pressure exerted thereupon.

6. Method according to any one of the previous claims wherein circuit elements (6) are mounted on the lower surface or the upper surface, or both, of the circuit board by an automated process.

7. Method according to claim 6 wherein the automated process comprises reflow process.

8. Circuit board (1) for assembly of circuit elements (6) comprising multiple layers (11, 12) formed by successive thin layers of conductive (12) and non-conductive (11) materials and a cavity for microstrip to waveguide transition means (2) in the form of a hollow space in the bulk of the circuit board (1), the circuit board being **characterized by** comprising an adhesive film (31) adhered onto a surface of the circuit board (1), the adhesive film being pre-cut in selected areas (32) thereof providing openings therethrough, a microelectronic substrate (33) placed upon the adhesive film, and metal layer (5) disposed on the resulting structure, wherein a selected part (51) of the metal layer (5) present on a surface of microelectronics substrate 33, facing the hollow space defined by the cavity for microstrip to waveguide transition means (2) is removed.

9. Circuit board according to claim 8, further comprising a protection layer (21) on the walls of the cavity for microstrip to waveguide transition means (2).

10. Circuit board according to claim 9, wherein the protection layer (21) is of NiAu alloy.

11. Circuit board according to any one of claims 8 to 10 further comprising thru-holes (14) at selected parts of the circuit board (1).

12. Circuit board according to any one of the claims 8 to 11 wherein the adhesive film (31) is substantially flow-resistant.

13. Circuit board according to any one of the claims 8 to 12 wherein circuit elements (6) are mounted on its lower surface or its upper surface, or both.

14. Use of the circuit board of any one of the claims 8 to 13 in radio frequency microwave transmission and/or reception equipment.
